# EUROPÄISCHE PATENTANMELDUNG

(11) **EP 1 772 531 A1**
(43) Veröffentlichungstag der Anmeldung: **11.04.2007**
(21) Anmeldenummer: 05021896.5
(22) Anmeldetag: 07.10.2005
(51) Int. Cl.: C23C 14/04, C23C 16/04, C23C 8/04

(54) **Verfahren und Vorrichtung zur Innenbeschichtung.**

(71) Anmelder: SIEMENS AKTIENGESELLSCHAFT, 80333 München (DE)
(72) Erfinder: Beck, Thomas, 16341 Panketal (DE); Berndt, Thomas, 12524 Berlin (DE); Ladru, Francis-Jurjen, Dr., 14050 Berlin (DE); Müller, Jean, 10589 Berlin (DE); Riemann, Michael, 12309 Berlin (DE)

(57) **Zusammenfassung**

Bei Innenbeschichtungsverfahren besteht häufig das Problem darin, dass eine äußere Oberfläche des zu beschichteten Bauteils mitbeschichtet wird.

Die erfindungsgemäße Vorrichtung (1) besteht darin, dass die äußere Oberfläche (28) durch eine stabile Außenhülle (4) und einem Füllmaterial (10) zwischen dem zu beschichtenden Bauteil (7, 120, 130) und der Außenhülle (4) geschützt ist.

## Beschreibung

Die Erfindung betrifft eine Vorrichtung für ein Beschichtungsverfahren eines Hohlkörpers gemäß Anspruch 1, eine Retorte gemäß Anspruch 5 und ein Verfahren zur Innenbeschichtung gemäß Anspruch 6.

Hohlkörper, wie z.B. gegossene Gasturbinenschaufeln weisen Hohlräume auf, die zwecks Korrosions- und/oder Oxidationsschutzes mit einer Innenbeschichtung, insbesondere einer metallischen Beschichtung versehen werden. Als Beschichtungsverfahren stehen hier Gasbeschichtungsverfahren zur Verfügung, wie z.B. das CVD- oder das PVD-Verfahren. Dabei wird das Metall für die Beschichtung mittels eines Trägergases in den Hohlraum geleitet und kondensiert dort auf den Innenflächen des Hohlkörpers. Dabei bildet sich dann beispielsweise eine metallische Korrosionsschutzschicht zwischen 30µm und 100µm Dicke. Das Trägergas wird in der Regel durch Öffnungen im Schaufelfuß der Turbinenschaufel eingeleitet, durchströmt den Hohlraum und tritt durch schaufelspezifische Öffnungen, z.B. an einer Austrittskante wieder aus. Die ganze Turbinenschaufel befindet sich dabei in einer Retorte in der gezielt Druck und Temperatur prozessspezifisch eingestellt werden können. Nach dem Ausströmen des Trägergases mit dem Metall aus der Austrittskante der Turbinenschaufel kondensiert das Metall in unerwünschter Weise auch auf der äußeren Oberfläche der Turbinenschaufel. Diese Beschichtungsreste müssen nach der Entnahme der Turbinenschaufel aus der Retorte aufwendig mittels Strahlen oder sonstigem abrasiven Verfahren entfernt werden. Dies dauert sehr lange und ist sehr personalintensiv.

Es ist daher Aufgabe der Erfindung eine Vorrichtung und eine Retorte aufzuweisen, mit der eine Beschichtung der äußeren Oberfläche während eines Innen-Beschichtungsverfahrens auf den zu beschichteten Bauteilen verhindert werden kann und ein Verfahren aufzuzeigen, durch das eine äußere Beschichtung bei einem Innen-Beschichtungsverfahren verhindert wird.

Die Aufgabe wird gelöst durch eine Vorrichtung gemäß Anspruch 1, durch eine Retorte gemäß Anspruch 5 und ein Verfahren gemäß Anspruch 6.

Weitere vorteilhafte Maßnahmen sind in den Unteransprüchen aufgelistet, die beliebig in vorteilhafter Art und Weise miteinander kombiniert werden können.

Es zeigen
- Figur 1: eine erfindungsgemäße Vorrichtung im Querschnitt I-I,
- Figur 2: eine perspektivische Ansicht einer erfindungsgemäße Vorrichtung,
- Figur 3: einen Querschnitt durch eine Turbinenschaufel,
- Figur 4: eine perspektivische Ansicht einer Turbinenschaufel,
- Figur 5: eine perspektivische Ansicht einer Gasturbine.

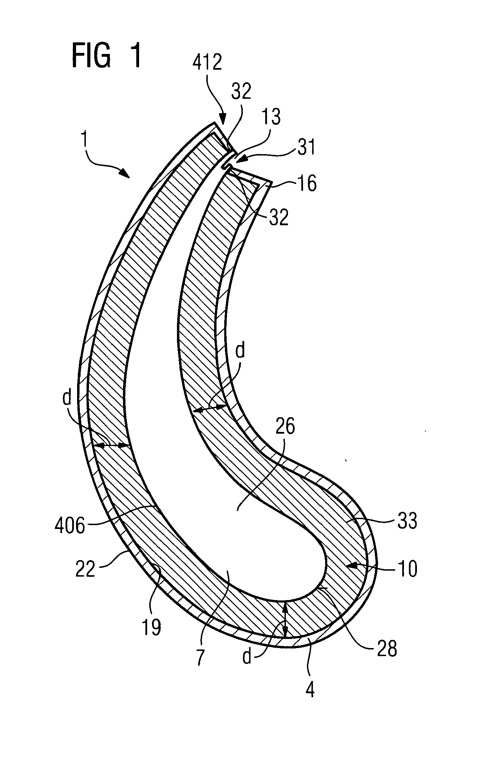

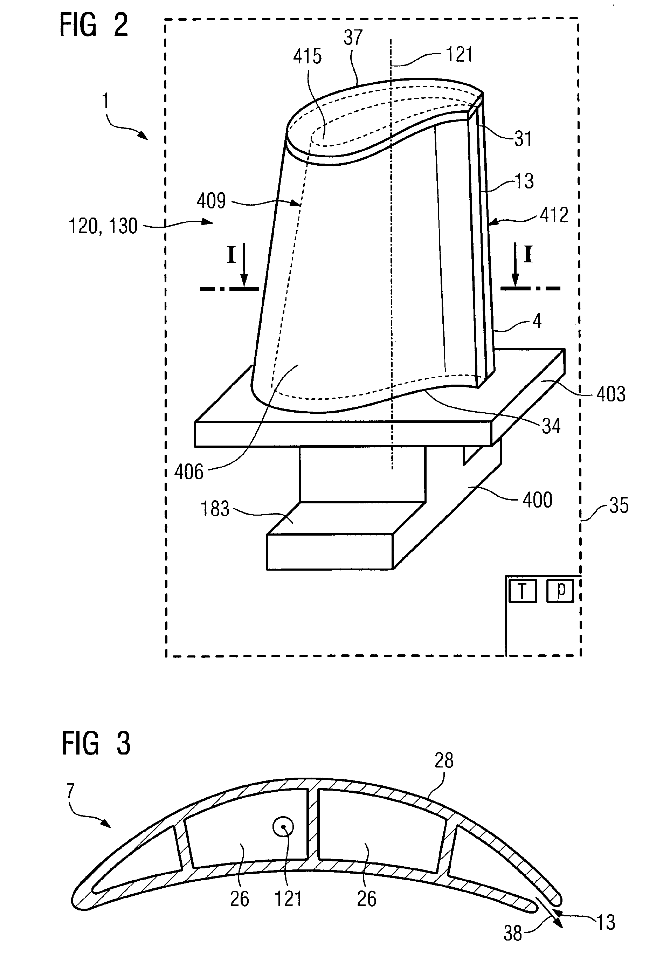

Figur 1 zeigt den Querschnitt durch eine erfindungsgemäße Vorrichtung 1.
Die Vorrichtung 1 umfasst eine stabile Außenhülle 4, die eine innere Oberfläche 19 und eine äußere Oberfläche 22 aufweist. In der Außenhülle 4 ist ein hohles Bauteil 7, insbesondere eine Turbinenschaufel 120, 130 (Fig. 3) angeordnet, für die die Vorrichtung 1 exemplarisch beschrieben wird.

Die Turbinenschaufel 120, 130 weist ein Hohlraum 26, eine äußere Oberfläche 28 und zumindest eine, insbesondere mehrere Austrittsöffnungen 13, vorzugsweise entlang einer Abströmkante 412 auf (Fig. 2), aus der in einer Ausströmrichtung 38 (Fig. 3) während des Betriebs der Turbinenschaufel 120, 130 ein Kühlmedium, ausströmt. Ebenso kann eine längliche Austrittsöffnung 13 vorhanden sein.

Die Außenhülle 4 ist vorzugsweise in ihrer Form der Kontur eines Schaufelblatts 406 der Turbinenschaufel 120, 130 angepasst, d.h. sie sieht von außen wie ein Schaufelblatt einer Turbinenschaufel aus. Generell könnte auch immer eine rechteckige Form für die Außenhülle 4 verwendet werden, jedoch würde dies bedeuten, dass dann der Abstand d zwischen dem Bauteil 7 und der Außenhülle 4 mit relativ viel Füllmaterial 10 aufzufüllen wäre.

Insbesondere handelt es sich bei dem Beschichtungsverfahren um ein Alitierungs- und/oder Chromierungsverfahren.
Als Beschichtungsverfahren stehen hier Gasbeschichtungsverfahren, wie z.B. das CVD- oder das PVD-Verfahren zur Verfügung. Dabei wird das Metall mittels eines Trägergases in der Regel durch Öffnungen im Schaufelfuß 400 der Turbinenschaufel 120, 130 eingeleitet in den Hohlraum 26 geleitet und kondensiert dort auf den Innenflächen der Turbinenschaufel 120 ,130, durchströmt den Hohlraum 26 und tritt durch schaufelspezifische Austrittsöffnungen 13, z.B. an der Austrittskante 412 wieder aus. Dabei bildet sich dann beispielsweise eine metallische Korrosionsschutzschicht zwischen 30µm und 100µm.

Ebenso ein beim Packverfahren verwendetes Material kann in den Hohlraum 26 eingebracht werden, das aus einem inerten Füller und Beschichtungsmaterial besteht (beispielsweise NaF + Al + Keramik oder AlF + Keramik), welches durch Erwärmung zur Aluminiumbeschichtung führt.

Ebenso kann ein Schlicker oder eine Paste in den Hohlraum 26 eingebracht werden, wobei dieser Schlicker oder die Paste erhitzt wird, so dass ein metallischer Dampf entsteht, der sich auf den Innenflächen des Hohlraums 26 niederschlägt.

Bezüglich der Auswahl der Beschichtungsverfahren des Hohlraums 26 besteht keinerlei Einschränkung.

Die Außenhülle 4 zeigt in Figur 1 eine Hüllenöffnung 31, durch die das Beschichtungsmaterial nach dem Austritt aus den Austrittsöffnungen 13 des Bauteils 120, 130 die Außenhülle 4 passieren kann.

Zwischen der äußeren Oberfläche 28 der Turbinenschaufel 120, 130 und der inneren Oberfläche 19 der äußeren vorzugsweise festen Außenhülle 4 besteht ein Abstand d, der groß genug ist, um diesen Innenraum 33 zwischen Außenhülle 4 und Turbinenschaufel 7 mit einem Füllmaterial 10 aufzufüllen. Vorzugsweise beträgt der Abstand d = 5 - 20mm. Der kürzeste Abstand d zwischen der Schaufeloberfläche 28 und der inneren Oberfläche 19 der äußeren Hülle muss nicht gleichmäßig sein, jedoch immer so groß sein, dass ein Füllmaterial 10 eingebracht werden kann.
Als Füllmaterial 10 wird vorzugsweise feines Al₂O₃-Pulver verwendet. Das Füllmaterial ist dabei so ausgewählt, dass es bei der Beschichtungstemperatur chemisch inert ist und so leicht wieder verwendet werden kann.
Natürlich können Abstandshalter in dem Innenraum 33 vorhanden sein, die einen Mindestabstand gewährleisten.

Die Außenhülle 4 ist also mindestens um 2 * d gegenüber der Turbinenschaufel 120, 130 verbreitert.

Da die Turbinenschaufel 120, 130 an der Hinterkante 412 spitz zuläuft, weist die Außenhülle 4 dort etwa eine Breite 2 * d auf. Die Außenhülle 4 läuft jedoch nicht, wie die Turbinenschaufel 120, 130 spitz zu, sondern weist einen abgeknickten Bereich 16 auf, der an seinem Ende an dem Bereich 32 an der Schaufel 120, 130 anliegt. So wird gewährleistet, dass auch im Bereich 32 der Austrittkante 412 ein ausreichend großer Abstand d zwischen Schaufelblatt 406 und Außenhülle 4 vorhanden ist.
Prinzipiell ist jedoch auch möglich, die Außenhülle 4 an ihrem Ende ebenfalls spitz zulaufen zu lassen.

Im Bereich 32 der Austrittskante 412 ist die Außenhülle 4 so angepasst, dass sie an der Turbinenschaufel 120, 130 nur in diesem Bereich 32 anliegt, so dass nur die Austrittsöffnungen 13 im Bereich der Hinterkante 412 freiliegen. Die Austrittsöffnungen 13 sind längs einer Linie (Hinterkante 412) angeordnet, so dass auch die Hüllenöffnung 31 dementsprechend vorzugsweise länglich ausgebildet ist.

Die Außenhülle 4 ist so konzipiert, dass sie für verschiedene Turbinenschaufeln 120, 130 verwendet werden kann, die verschiedene Längen und verschiedenen Krümmungen aufweisen können, also beispielsweise für Turbinenschaufeln 120, 130 verschiedener Schaufelstufen. Somit kann für verschiedene Turbinenschaufeln 120, 130 eine standardisierte Außenhülle 4 verwendet werden, da die Abstände d variabel mit dem Füllmaterial 10 ausgeglichen werden können.

Figur 2 zeigt die erfindungsgemäße Vorrichtung 1 in dreidimensionaler Darstellung.
Die Außenhülle 4 umschließt das Schaufelblatt der Turbinenschaufel 120, 130 vollkommen und liegt beispielsweise auf der Plattform 403 auf. Gegebenenfalls wird die Außenhülle 4 an den Berührungsflächen 34 mit der Schaufelplattform 403 abgedichtet. Ebenso können die Berührungsflächen im Bereich 32 der Hüllenöffnung 31 mit der Außenhülle 4 mit der Turbinenschaufel 7 abgedichtet werden.
Die Abdichtung ist in der Regel nicht notwendig, da das Füllmaterial 10 ein Eindringen von Material zwischen Außenhülle 4 und Turbinenschaufel 120, 130 verhindert und so das Schaufelblatt 406 vor einer Beschichtung schützt. Allenfalls kann eine Abdichtung dazu benutzt werden, um ein Auslaufen von Füllmaterial 10 aus der Außenhülle 4 verhindern.

Die Außenhülle 4 kann beispielsweise einen Deckel 37 aufweisen, durch den das Füllmaterial 10 in den Innenraum 33 zwischen den Schaufelblatt und der Außenhülle 4 eingefüllt wird.

Danach kann der Deckel 37 wieder verschlossen oder zugelötet werden.
Andere Arten der Einbringung des Füllmaterials 10 sind ebenfalls denkbar. Es ist daher ebenso möglich keinen Deckel 37 zu verwenden, sondern den Innenraum 33 zwischen Schaufelblatt 406 und Außenhülle 4 aufzufüllen und eine Schaufelspitze 415 ebenfalls mit Füllmaterial 10 zu bedecken, da die Außenhülle 4 nur die Aufgabe hat, das Füllmaterial 10 zusammenzuhalten.

Vorzugsweise ist die erfindungsgemäße Vorrichtung 1 in einer Retorte 35 angedeutet, die in Figur 2 gestrichelt gezeichnet angedeutet ist.
Innerhalb der Retorte 35 kann die Temperatur T und/oder der Druck p kontrolliert eingestellt und überwacht werden, wobei die Temperatur T und der Druck P auch an dem Bauteil 7, 120, 130 anliegt, so dass das Beschichtungsverfahren in der Turbinenschaufel 120, 130 kontrolliert durchgeführt werden kann. Die Retorte 35 kann eine Pumpe aufweisen, die das aus der Außenhülle 4 austretende Beschichtungsmaterial absaugt.

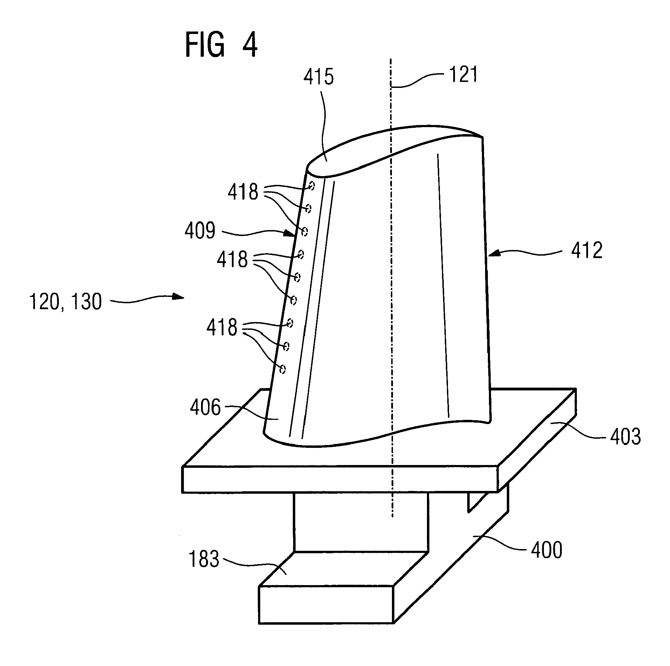

Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf.
Als Leitschaufel 130 kann die Schaufel 130 an ihrer Schaufelspitze 415 eine weitere Plattform aufweisen (nicht dargestellt) .

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweit genannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.
Für eine Innenbeschichtung wird das erfindungsgemäße Verfahren verwendet.

Auf der MCrAlX kann noch eine Wärmedämmschicht vorhanden sein und besteht beispielsweise aus ZrO₂,Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt oder z.B. atmosphärisches Plasmaspritzen (APS) poröse, mikro- und makrorissbehaftete Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

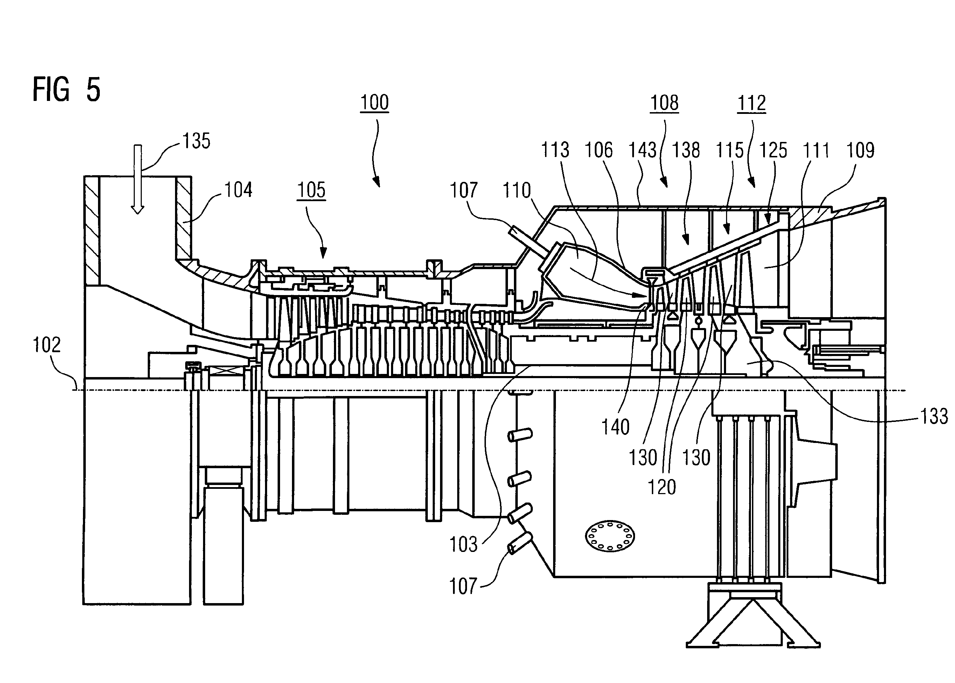

Die Figur 5 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949
bekannt; diese Schriften sind bzgl. der chemischen Zusammensetzung der Legierungen Teil der Offenbarung.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

## Patentansprüche

1. Vorrichtung für ein Beschichtungsverfahren eines Hohlraums (26) eines hohlen Bauteils (7, 120, 130),
umfassend
eine stabile Außenhülle (4),
in die das hohle Bauteil (7, 120, 130) mit einem Abstand (d) zu einer Innenfläche (19) der Außenhülle (4) einführbar ist,
und ein Füllmaterial (10) zwischen dem hohlen Bauteil (7) und der Außenhülle (4),
wobei die Außenhülle (4) nur teilweise in einem Bereich (32) des Bauteils (7, 120, 130),
insbesondere im Bereich (32) von zumindest einer Austrittsöffnung (13) des hohlen Bauteils (7, 120, 130) anliegt und
wobei die Außenhülle (4) in dem Bereich (32) eine Hüllenöffnung (31) aufweist,
an der ein Beschichtungsmaterial während des Beschichtungsverfahrens austreten kann.

2. Vorrichtung nach Anspruch 1,
bei der die Außenhülle (4) der äußeren Kontur des Bauteils (7, 120, 130) angepasst ist.

3. Vorrichtung nach Anspruch 1 oder 2,
bei der das hohle Bauteil (120, 130) eine Turbinenschaufel ist.

4. Vorrichtung nach Anspruch 1, 2 oder 3,
bei der die Hüllenöffnung (31) länglich ausgebildet ist.

5. Retorte (35),
in der die Vorrichtung (1) nach einem oder mehreren der Ansprüche 1 bis 4 angeordnet ist,
wobei in der Retorte Temperatur (T) und Druck (p) einstellbar ist,
die auch an dem Bauteil (7, 120, 130) anliegen.

6. Verfahren zur Innenbeschichtung eines hohlen Bauteils (7, 120, 130) mit einem Hohlraum (26),
das folgende Schritte umfasst:
Einführen des hohlen Bauteils (7, 120, 130) in eine stabile Außenhülle (4),
wobei die Außenhülle (4) nur teilweise im Bereich (32) zumindest einer Austrittsöffnung (13) des Bauteils (7, 120, 130) anliegt,
Auffüllen des Abstands (d) zwischen der Innenfläche (19)
der Außenhülle (4) und des Bauteils (7, 120, 130) mit einem Füllmaterial (10),
Einbringen von Beschichtungsmaterial in den Hohlraum (26), so dass sich das Beschichtungsmaterial in dem Hohlraum (26) niederschlägt,
wobei zumindest ein Teil des Beschichtungsmaterials aus dem Hohlraum (26) durch die zumindest eine Austrittsöffnung (13) aus dem Bauteil (7, 120, 130) austritt.

7. Verfahren nach Anspruch 6,
bei dem ein Alitierungsverfahren durchgeführt wird.

8. Verfahren nach Anspruch 6 oder 7,
bei dem das Füllmaterial (10) bei den Beschichtungstemperaturen chemisch inert ist.

## Geänderte Patentansprüche

### Geänderte Patentansprüche gemäss Regel 86(2) EPÜ.

**1.** Vorrichtung für ein Beschichtungsverfahren eines Hohlraums (26) eines hohlen Bauteils (7, 120, 130),
umfassend
eine stabile Außenhülle (4),
die auf einer Schaufelplattform (403) des Bauteils (7, 120, 130) aufliegt,
in die das hohle Bauteil (7, 120, 130) mit einem Abstand (d) zu einer Innenfläche (19) der Außenhülle (4) einführbar ist,
und ein Füllmaterial (10) zwischen dem hohlen Bauteil (7) und der Außenhülle (4),
wobei die Außenhülle (4) nur teilweise in einem Bereich (32) des Bauteils (7, 120, 130),
insbesondere im Bereich (32) von zumindest einer Austrittsöffnung (13) des hohlen Bauteils (7, 120, 130) anliegt und
wobei die Außenhülle (4) in dem Bereich (32) eine Hüllenöffnung (31) aufweist,
an der ein Beschichtungsmaterial während des Beschichtungsverfahrens austreten kann.

**2.** Vorrichtung nach Anspruch 1,
bei der die Außenhülle (4) der äußeren Kontur des Bauteils (7, 120, 130) angepasst ist.

**3.** Vorrichtung nach Anspruch 1 oder 2,
bei der das hohle Bauteil (120, 130) eine Turbinenschaufel ist.

**4.** Vorrichtung nach Anspruch 1, 2 oder 3,
bei der die Hüllenöffnung (31) länglich ausgebildet ist.

**5.** Retorte (35),
in der die Vorrichtung (1) nach einem oder mehreren der Ansprüche 1 bis 4 angeordnet ist,
wobei in der Retorte Temperatur (T) und Druck (p) einstellbar ist,
die auch an dem Bauteil (7, 120, 130) anliegen.

**6.** Verfahren zur Innenbeschichtung eines hohlen Bauteils (7, 120, 130) mit einem Hohlraum (26),
das folgende Schritte umfasst:
Einführen des hohlen Bauteils (7, 120, 130) in eine stabile Außenhülle (4),
so dass die Außenhülle (4) auf einer Schaufelplattform (403) des Bauteils aufliegt,
wobei die Außenhülle (4) nur teilweise im Bereich (32) zumindest einer Austrittsöffnung (13) des Bauteils (7, 120, 130) anliegt,
Auffüllen des Abstands (d) zwischen der Innenfläche (19) der Außenhülle (4) und des Bauteils (7, 120, 130) mit einem Füllmaterial (10),
Einbringen von Beschichtungsmaterial in den Hohlraum (26), so dass sich das Beschichtungsmaterial in dem Hohlraum (26) niederschlägt,
wobei zumindest ein Teil des Beschichtungsmaterials aus dem Hohlraum (26) durch die zumindest eine Austrittsöffnung (13) aus dem Bauteil (7, 120, 130) austritt.

**7.** Verfahren nach Anspruch 6,
bei dem ein Alitierungsverfahren durchgeführt wird.

**8.** Verfahren nach Anspruch 6 oder 7,
bei dem das Füllmaterial (10) bei den Beschichtungstemperaturen chemisch inert ist.
